# EUROPÄISCHE PATENTSCHRIFT

(11) **EP 1 472 915 B1**
(45) Veröffentlichungstag und Bekanntmachung des Hinweises auf die Patenterteilung: **08.03.2006**
(21) Anmeldenummer: 03706279.1
(22) Anmeldetag: 05.02.2003
(51) Int. Cl.: H05K 1/11, H05K 3/40

(54) **SCHALTUNGSTRÄGER UND HERSTELLUNG DESSELBEN**
CIRCUIT CARRIER AND PRODUCTION THEREOF
SUPPORT DE CIRCUIT ET PRODUCTION DE CE SUPPORT

(30) Priorität: 08.02.2002 DE 10205450
(43) Veröffentlichungstag der Anmeldung: 03.11.2004
(73) Patentinhaber: Infineon Technologies AG, 81669 München (DE)
(72) Erfinder: MÜNCH, Thomas, 93164 Laaber (DE)
(74) Vertreter: Schäfer, Horst
(86) Internationale Anmeldenummer: PCT/DE2003/000321
(87) Internationale Veröffentlichungsnummer: WO 2003/067940

(56) Entgegenhaltungen:
- EP-A- 0 436 943
- WO-A-93/01634
- DE-A- 19 543 894
- US-A- 4 095 866
- PATENT ABSTRACTS OF JAPAN vol. 1999, no. 14, 22. Dezember 1999 (1999-12-22) & JP 11 261185 A (AMP JAPAN LTD), 24. September 1999 (1999-09-24)

## Beschreibung

Die Erfindung betrifft einen Schaltungsträger und die Herstellung desselben gemäß der Gattung der unabhängigen Ansprüche.

Für den Aufbau komplexer Schaltungen sind Schaltungsträger erforderlich, die einlagig, doppelseitig oder mehrlagig strukturierte Metallschichten mit Leiterbahnen aufweisen. Diese Leiterbahnen werden teilweise über Durchkontakte mit elektronischen Bauteilen verbunden, die auf bzw, in dem Schaltungsträger angeordnet sind. In einem ihrer Randbereiche weisen derartige Schaltungsträger Flachsteckerleisten auf, die dazu dienen, den Schaltungsträger mit seinen elektronischen Bauteilen mit anderen Schaltungsträgern beispielsweise über BUS-Leitungen zu verbinden. Derartige Flachsteckerleisten müssen von Bauelementen und elektronischen Bauteilen freigehalten bleiben, damit sie in entsprechende Steckerbuchsen eingebracht werden können. Außerdem müssen die Oberflächen der Anschlusskontakte einer Flachsteckerleiste eben und frei von Störungen sein. Somit haben Schaltungsträger mit Flachsteckern den Nachteil, dass die Schaltungsträgerfläche im Bereich der Flachsteckerleisten für keine weiteren Funktionen benutzt werden können. Im Zuge der Miniaturisierung ist es jedoch notwendig, auch über die Möglichkeit, die Flächen der Flachsteckerleisten für weitere Funktionen des Schaltungsträgers zu nutzen.

In der US 4,095,866 sind Schaltungsträger beschrieben, die als Flachstecker verwendet werden können. Sie sind mit Durchgangslöchern versehen, um eine Verbindung zwischen Außenanschlüssen und inneren Kontaktleisten herzustellen. Dabei wird jedoch die Oberfläche des Flachsteckers durchbrochen, so dass ihre ebene Glätte gestört wird.

Aufgabe der Erfindung ist es, einen Schaltungsträger mit Anschlusskontakten einer Flachsteckerleiste anzugeben, wobei die Oberseite der Anschlusskontakte eine ungestörte Morphologie und ebene Oberfläche aufweisen soll, während das Schaltungsträgervolumen im Bereich der Flachsteckerleiste zur Miniaturisierung des Schaltungsträgers beitragen soll.

Diese Aufgabe wird mit dem Gegenstand der unabhängigen Ansprüche gelöst. Vorteilhafte Weiterbildungen der Erfindung ergeben sich aus den abhängigen Ansprüchen.

Erfindungsgemäß weist der Schaltungsträger ein Substrat mit zwei gegenüberliegend angeordneten Flächen auf. Mindestens ein Randbereich des Substrats weist mindestens auf einer seiner Flächen Anschlusskontakte einer Flachsteckerleiste auf. Dabei sind die Anschlusskontakte in einem vorgegebenen Rastermaß angeordnet. Unter mindestens einem der Anschlusskontakte ist ein Durchkontakt mit verdeckter elektrischer Verbindung zu der Rückseite des Anschlusskontaktes angeordnet, wobei die Oberseite des Anschlusskontaktes eine ungestörte Morphologie und ebene Oberfläche aufweist.

Dieser Schaltungsträger hat den Vorteil, dass die Fläche der Anschlusskontakte genutzt wird, um die Anbindung der Anschlusskontakte an die Verdrahtung des Schaltungsträgers nicht außerhalb des Bereichs der Anschlusskontakte durchzuführen und damit Fläche zu verbrauchen, sondern innerhalb des Bereichs der Anschlusskontakte anzuordnen. Durch das Anbinden der Leiterbahnen des Schaltungsträgers an die Anschlusskontakte unmittelbar unter den Anschlusskontakten werden die Leiterbahnen eines Schaltungsträgers wesentlich verkürzt und damit die Gesamtgröße des Schaltungsträgers vermindert. Von dem Durchkontakt mit vom Anschlusskontakt verdecktem Durchgangsloch können jedoch nicht nur Leiterbahnen ausgehen, sondern auch Bonddrähte angeschlossen werden und die freiliegende Rückseite eines Anschlusskontaktes im Bereich eines Durchkontaktes kann für weitere Verbindungen genutzt werden, ohne dass die Oberseite des Anschlusskontaktes in ihrer Morphologie gestört wird.

Der Durchkontakt kann eine metallische Wandbeschichtung aufweisen, welche die Rückseite des Anschlusskontaktes berührt. Eine derartige Ausführungsform der Erfindung hat den Vorteil, dass der Durchkontakt in seinem Durchmesser so groß gewählt werden kann, dass die Rückseite der Anschlusskontakte auf fast voller Breite freigelegt werden kann, um die Rückseite der Anschlusskontakte für weitere Verbindungen zu nutzen. Somit erfüllt der Durchkontakt eine Mehrfachverbindungsfunktion einerseits über die Wandbeschichtung und andererseits über die freigelegte Rückseite der Anschlusskontakte.

Weiterhin kann der Durchkontakt eine metallische Füllung aufweisen, welche die Rückseite des Anschlusskontaktes berührt. In diesem Fall kann auf dem gefüllten Bereich des Durchkontaktes ebenfalls eine weitere Anbindung, beispielsweise eines Bonddrahtes erfolgen. Mit einem derartigen Durchkontakt wird der Widerstand des Durchkontaktes erheblich vermindert, so dass dieser Durchkontakt gegenüber einem Durchkontakt mit metallischer Wandbeschichtung einen Vorteil in der Größenordnung des Kontaktwiderstandes aufweist.

Der Durchkontakt kann auch eine Füllung aus elektrisch leitendem Kunststoff aufweisen, welcher die Rückseite des Anschlusskontaktes berührt. Derartige Füllungen sind relativ leicht in die Öffnung des Durchkontaktes einbringbar, ohne dass der Anschlusskontakt von der Rückseite aus beschädigt wird und somit eine ungestörte Morphologie der Oberfläche des Anschlusskontaktes erhalten bleibt.

weiterhin kann die von den Anschlusskontakten abgewandte Fläche des Substrats mindestens eine Leiterbahn aufweisen, die mit dem Durchkontakt verbunden ist. Die Anzahl der Leiterbahnen, die mit einem derartigen Durchkontakt verbunden werden können hängt lediglich von der Breite der Leiterbahn und dem Umfang der Wandbeschichtung des Durchkontaktes ab. Somit kann der Anschlusskontakt im Bereich der Fläche, die er benötigt, zusätzlich mit mehreren Leiterbahnen auf der gegenüberliegenden Fläche des Substrats elektrisch verbunden sein, so dass sogar elektrische Knotenpunkte im Bereich der Fläche von Anschlusskontakten realisiert werden können.

Leiterbahnen, die auf der den Anschlusskontakten gegenüberliegenden Fläche des Substrats angeordnet sind, können Metalle wie Kupferlegierungen, Nickellegierungen, Aluminiumlegierungen, Silberlegierungen oder Goldlegierungen aufweisen. Jedoch lassen sich auch Leiterbahnen aus elektrisch leitendem Kunststoff verwirklichen. Diese Leiterbahnen haben den Vorteil, dass sie noch nachträglich aufgebracht werden können, das heißt, sie müssen nicht gleichzeitig mit der Strukturierung der Leiterbahnen auf dem Substrat komplett fertiggestellt werden. Vielmehr kann der Kunde mit Hilfe von Leiterbahnen aus elektrisch leitendem Kunststoff nachträglich Verbindungen relativ einfach vornehmen und somit den Schaltungsträger modifizieren.

Außerdem ist es vorgesehen, einen Bonddraht in dem Durchkontakt anzuordnen, der unmittelbar auf die Rückseite des Anschlusskontaktes gebonded ist. Mit einer derartigen Bondverbindung wird eine Vielfachverwendung der Fläche des Anschlusskontaktes realisiert, da nicht nur Leiterbahnen an den Durchkontakt angeschlossen werden, sondern auch die freiliegende Rückseite des Anschlusskontaktes im Bereich des abgedeckten Durchkontaktloches für Bondverbindungen zur Verfügung steht.

Sowohl für die Leiterbahn aus elektrisch leitendem Kunststoff als auch für ein Auffüllen der Durchkontakte mit elektrisch leitendem Kunststoff wird die verwendete Kunststoffmasse mit elektrisch leitenden Mikro- oder Nanopartikeln aufgefüllt. Diese Füllmaterialien weisen Gold, Silber, Nickel, Kupfer oder Aluminium oder Legierungen derselben auf, wobei Nanopartikelgrößen den Vorteil haben, dass die gefüllte Kunststoffmasse feiner strukturiert auf das Substrat aufgebracht werden kann als mit Mikropartikeln.

Als elektrisch leitender Kunststoff können W-härtende oder temperaturhärtende Kunststoffe eingesetzt werden. Als Ausgangsstoff für einen der elektrisch leitenden Kunststoffe hat sich ein mit Nanopartikeln angereichertes in N-methyl-Pyrrolidin gelöstes Polyamidessigsäureester erwiesen. Dieser in N-methyl-Pyrrolidin gelöster Polyamidessigsäureester kann als Füllmaterial für die Durchkontakte oder als Leiterbahn auf das Substrat aufgetragen werden und wird anschließend bei erhöhter Temperatur zu einem festen elektrisch leitenden Kunststoff vernetzt. Dem Kunststoff kann jedoch vorher noch ein Katalysatormaterial oder ein Haftvermittler in der Kunststoffgrundmasse aus Polyamid zugegeben werden, um einerseits die Leitfähigkeit zu verbessern und andererseits die Haftung auf dem Substrat der Leiterbahnen zu steigern.

Der Schaltungsträger kann als Substrat zwei Schaltungsplatten mit dazwischen in Kunststoffmasse eingebetteten Halbleiterchips aufweisen. Diese Ausführungsform hat den Vorteil, dass dem Halbleiterchip ein außergewöhnlicher Schutz gegen mechanische Beanspruchung und eine intensive Kühlung gegen thermische Belastung gewährt wird, zumal die Anschlusskontakte großflächige Wärmesenken einer Schaltung darstellen. Mit den beiden Schaltungsplatten kann gleichzeitig eine Anordnung von Anschlusskontakten realisiert werden, die auf beiden Seiten des Schaltungsträgers voneinander isolierte Anschlusskontakte aufweisen. Neben der intensiven Nutzung des Schaltungsträgers im Bereich der Anschlusskontakte durch Anbringung von Halbleiterchips wird hier gleichzeitig die Anzahl der Anschlusskontakte einer Flachsteckerleiste auf zwei Oberflächen verteilt und damit der Gesamtflächenbedarf halbiert.

Eine weitere Verdichtung der Schaltung im Flachsteckerbereich kann durch Einsetzen von mehrlagigen Leiterplatten als Substrat erreicht werden. Die einzelnen Leiterbahnlagen können für Schaltungsmodule zusätzlich Strukturen für passive Bauelemente, wie Widerstände, Kondensatoren und Induktivitäten aufweisen.

In der Hochfrequenz- und Höchstfrequenzanwendung können Substrate aus mehrlagigen Keramikplatten verwendet werden und die Volumina unter den Anschlusskontakten bereits für eine intensive und kompakte Verdrahtung genutzt werden.

Ein Verfahren zur Herstellung eines Schaltungsträgers, der ein Substrat mit Anschlusskontakten in einem vorgegebenen Rastermaß aufweist, wobei mindestens ein Durchkontakt unter einem der Anschlusskontakte mit verdeckter elektrischer Verbindung zu der Rückseite des Anschlusskontaktes angeordnet ist, weist nachfolgende Verfahrensschritte auf.

Zunächst wird ein isolierendes Substrat bereitgestellt. In dieses isolierende Substrat werden Durchgangslöcher eingebracht in Bereichen, in denen Anschlusskontakte vorgesehen sind. Die Wandungen der Durchgangslöcher können anschließend mit Metall beschichtet werden, ohne dass bereits Anschlusskontakte die Durchgangslöcher abdecken. Danach werden die Anschlusskontakte aufgebracht und gleichzeitig werden dabei die metallisierten Durchgangslöcher abgedeckt. Dazu kann eine auf den Durchgangslöchern selbsttragende und formstabile Metallfolie auf dem Substrat fixiert und anschließend strukturiert werden. Durch das Aufbringen der selbsttragenden Metallfolie mit einer Metallfoliendicke zwischen 18 µm bis 150 µm wird eine elektrische Verbindung zwischen Metallfolie und der Metallisierung der Durchgangslöcher hergestellt und eine formstabile Abdeckung des Durchkontaktes mit Durchgangsloch geschaffen. Mit der Strukturierung der Metallfolie können einerseits die Anschlusskontakte strukturiert werden und auch Leiterbahnen für eine Bestückung des Substrats mit Halbleiterbauteilen vorbereitet werden.

Dieses Verfahren hat den Vorteil, dass nun ein Schaltungsträger zur Verfügung steht, bei dem die Fläche der Anschlusskontakte für ein Durchkontaktieren und ein elektrisches Verbinden der Anschlusskontakte mit elektronischen Bauteilen auf der Rückseite des Schaltungsträgers realisiert werden kann. Dazu werden in gleicher Weise wie auf der Oberseite auch auf der Rückseite Metallfolien aufgebracht, die zu Leiterbahnen strukturiert werden können. Im Bereich der Anschlusskontakte können dann diese Leiterbahnen in Verbindung mit dem Durchkontakt stehen. Über die Leiterbahnen können Halbleiterchips in Flip-Chip-Technik unmittelbar mit den Durchkontakten im Bereich der Anschlusskontakte verbunden werden. Ist der Halbleiterchip für eine Bondtechnik vorgesehen, so können die Bonddrähte auf den Kontaktflächen des Halbleiterchips befestigt werden und direkt zur Rückseite des Anschlusskontaktes durch den Durchkontakt hindurchgeführt werden.

Eine weitere Möglichkeit, Durchkontakte im Bereich von Anschlusskontakten zu realisieren besteht darin, dass die Durchgangslöcher nicht vor dem Aufbringen der Metallisierung hergestellt werden, sondern mit Hilfe von Laserabtrag Durchgangslöcher nach dem Aufbringen der Metallisierung durch das Substrat hindurch geschaffen werden, wobei der Abtrag an der Grenzfläche zu den Anschlusskontakten zum Stehen kommt und somit die Morphologie der Oberseite des Anschlusskontaktes ungestört erhalten bleibt.

Eine weitere Möglichkeit zur Herstellung eines Schaltungsträgers besteht darin, nach einem Einbringen von Durchgangslöchern in ein isolierendes Substrat dieses Substrat beidseitig mit einer nicht selbsttragenden Metallfolie zu beschichten, die eine Dicke gleich oder kleiner als 18 µm aufweist. Anschließend wird die Metallfolie durch eine Photolackstrukturierung derart strukturiert, daß die Durchgangslöcher einseitig von der Metallfolie abgedeckt bleiben, nämlich auf der Substratseite, die für Anschlußkontakte vorgesehen ist. Anschließend werden die entstandenen Metallstrukturen auf beiden Substratseiten galvanisch verstärkt und auf den Durchgangslöchern eine Metallbeschichtung abgeschieden. Ein derartiges Verfahren hat den Vorteil, daß ein höherer Grad an Feinstrukturierung erreicht werden kann, da die Foliendicke äußerst gering ist.

Zusammenfassend ist festzustellen, dass die Platzierung von einer oder mehreren abgedeckten Hohlraumstrukturen, die auch "tented via" oder "tented blind via" genannt werden, in dem Bereich der Metallisierung der Anschlusskontakte einer Flachsteckerleiste - genannt "edge connector pads" - bei elektronischen Baugruppen, bestehend aus mindestens einem integrierten Schaltkreis und eventuell bestimmter passiver Zusatzelemente, wie Widerstände, Kapazitäten oder Induktivitäten, dem Flachbaugruppenkonstrukteur ermöglicht, eine bessere Effizienz im Hinblick auf Anforderungen mit hoher Verdrahtungsdichte.- genannt "high density interconnect wiring" - und/oder bei eingeschränktem Platz ("limited real estate") bei der Anordnung oder dem sogenannten "Placement" und der Verbindungstechnik, wie einer "Surface- mount-Technologie" der Bestükkungselemente, den sogenannten "components", zu erreichen.

Bisher wird diese erfindungsgemäße Platzierung von abgedeckten Hohlraumstrukturen unterhalb der Anschlusskontakte bei Steckerleisten und anderen Anwendungen nicht genutzt. Vielmehr wird diese Verbindung außerhalb der Anschlusskontakte mittels metallisierter Öffnungen, den sogenannten "plated vias" realisiert, die mit Lötstopplack oder mit Lot abgedeckt sein können. Diese Technologie hat den Nachteil, dass sie einen hohen Platzbedarf benötigt und somit eine Miniaturisierung der Schaltungsträger nicht weiter zulässt. Jedoch wird die Geometrie der Anschlusskontakte nicht durch Öffnungen, wie den sogenannten "vias" oder durch Lotpunkte beziehungsweise durch Lötstopplackpunkte gestört. Jede Öffnung im Bereich der Anschlusskontakte würde die Oberfläche und Morphologie des Anschlusskontaktes sichtbar verletzen und bei schleifenden Kontakten eine Verletzung der zunächst homogenen Metallfläche des Steckkontaktes verursachen.

Somit liefert die vorliegende Erfindung ein Design einer 100%ig leitfähig abgedeckten Durchkontaktöffnung mit ungestörter Morphologie unterhalb der Fläche der Steckkontakte auf den Außenlagen kombiniert mit einer homogenen Kontaktfläche ohne mechanische Fehlkontaktierung mit der Möglichkeit, unter dem Anschlusskontakt eine vergrabene Anbindung von Leiterbahnen auf Innenlagen von mehrlagigen Leiterplatten oder durch Anbindung der Rückseite der Anschlusskontakte mit Hilfe von einem Durchkontakt und weiterleitenden Kontaktierungsverfahren, wie Löten, Kleben und Bonden, insbesondere bei zweilagigen Schaltungsträgern, zu realisieren. Der Gegenstand der Erfindung kann bei vielen Baugruppen und Produkten, zum Beispiel einer Multi-Media-Karte, die gehäuse- oder designbedingt in einer Ausführungsform mit Flachsteckkontakten bisher auf dem Markt sind, eingesetzt werden, und damit ein erheblicher Minimierungsgrad für diese Produkte erreicht werden.

Die Erfindung wird nun anhand von Ausführungsformen mit Bezug auf die beiliegenden Figuren näher erörtert.
- Figur 1: zeigt einen schematischen Querschnitt durch einen Schaltungsträger gemäß einer ersten Ausführungsform der Erfindung,
- Figur 2: zeigt einen schematischen Querschnitt durch einen Schaltungsträger gemäß einer zweiten Ausführungsform der Erfindung,
- Figur 3: zeigt einen schematischen Querschnitt durch einen Schaltungsträger gemäß einer dritten Ausführungsform der Erfindung,
- Figur 4: zeigt einen schematischen Querschnitt durch einen Schaltungsträger einer vierten Ausführungsform der Erfindung aus zwei Komponenten vor einem Zusammenbau derselben,
- Figur 5: zeigt einen schematischen Querschnitt durch einen Schaltungsträger gemäß der vierten Ausführungsform der Erfindung nach einem Zusammenbau der zwei Komponenten,
- Figur 6: zeigt einen schematischen Querschnitt durch einen Schaltungsträger gemäß einer fünften Ausführungsform der Erfindung,
- Figur 7: zeigt einen schematischen Querschnitt durch einen Schaltungsträger gemäß einer sechsten Ausführungsform der Erfindung,
- Figur 8: zeigt einen schematischen Querschnitt durch einen Schaltungsträger gemäß einer siebten Ausführungsform der Erfindung,
- Figur 9: zeigt eine Draufsicht auf eine Bestückungsseite eines Schaltungsträgers,
- Figur 10: zeigt eine Draufsicht auf eine Bestückungsseite eines Schaltungsträgers einer weiteren Ausführungsform der Erfindung,

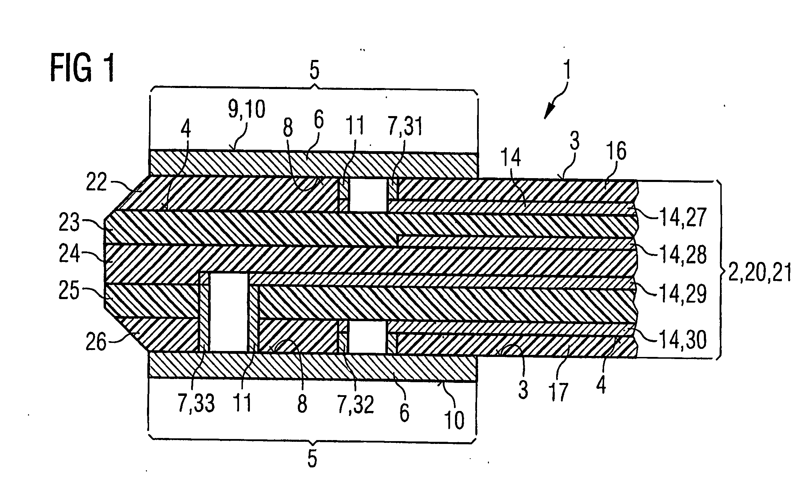

Figur 1 zeigt einen schematischen Querschnitt durch einen Schaltungsträger 1 gemäß einer ersten Ausführungsform der Erfindung. Das Bezugszeichen 2 kennzeichnet ein Substrat, das in dieser Ausführungsform der Erfindung entweder eine mehrlagige Leiterplatte 20 oder eine mehrlagige Keramikplatte 21 sein kann. Die Bezugszeichen 3 und 4 kennzeichnen einander gegenüberliegende Flächen des Substrats beziehungsweise einander gegenüberliegende Flächen der einzelnen Leiterplattenlage oder Keramikplattenlage. Das Bezugszeichen 5 kennzeichnet den Randbereich des Schaltungsträgers 1, der Anschlusskontakte 6 eines Flachsteckers aufweist.

Ein derartiger Flachstecker ist in Kammstruktur angeordnet, wobei Figur 1 nur den Querschnitt eines Anschlusskontaktes 6 auf der Oberseite des Schaltungsträgers 1 und eines Anschlusskontaktes 6 auf der Rückseite des Schaltungsträgers 1 im Querschnitt zeigt. Der mehrlagige Schaltungsträger 1 dieser ersten Ausführungsform der Erfindung weist fünf Isolationslagen 22 bis 26 auf, zwischen denen vier Leiterbahnlagen 27 bis 30 angeordnet sind. Unter der Fläche der Anschlusskontakte 6 sind Durchkontakte 31, 32 und 33 ohne Störung der Morphologie und der Ebenheit der Oberflächen der Anschlusskontakte 6 angeordnet. Diese Durchkontakte 31, 32 und 33 verbinden elektrisch die Anschlusskontakte 6 mit den unterschiedlichen Leiterbahnlagen 27, 28, 29 und 30, wobei in dieser Ausführungsform der Anschlusskontakt 6 auf der Oberseite des Schaltungsträgers 1 über den Durchkontakt 31 mit Leiterbahnen in der Leiterbahnlage 27 verbunden ist und der Anschlusskontakt 6 auf der Unterseite des Schaltungsträgers 1 mit der Leiterbahnlage 29 über den Durchkontakt 33 und mit der Leiterbahnlage 30 über den Durchkontakt 32 verbunden ist.

Somit wird die Fläche des Schaltungsträgers 1 unter den Anschlusskontakten 6 beziehungsweise zwischen den Anschlusskontakten 6 genutzt, um dadurch die Leiterbahn zwischen den Elektroden von Halbleiterbauelementen auf dem Schaltungsträger 1 und den Anschlusskontakten 6 zu verkürzen. Dabei wird die Ebenheit und die Morphologie der Anschlusskontakte 6, insbesondere ihrer Oberflächen 10, nicht gestört, so dass eine hervorragende Gleitkontaktgabe der Flachsteckerleiste gewährleistet bleibt. Die Durchkontakte 31, 32 und 33 stellen in dieser Ausführungsform der Erfindung gemäß Figur 1 abgedeckte Hohlräume dar, wobei die Wandungen 7 der Hohlräume metallisiert sind und die elektrische Verbindung zwischen Anschlusskontakten 6 und Leiterbahnlagen 27 bis 30 herstellen.

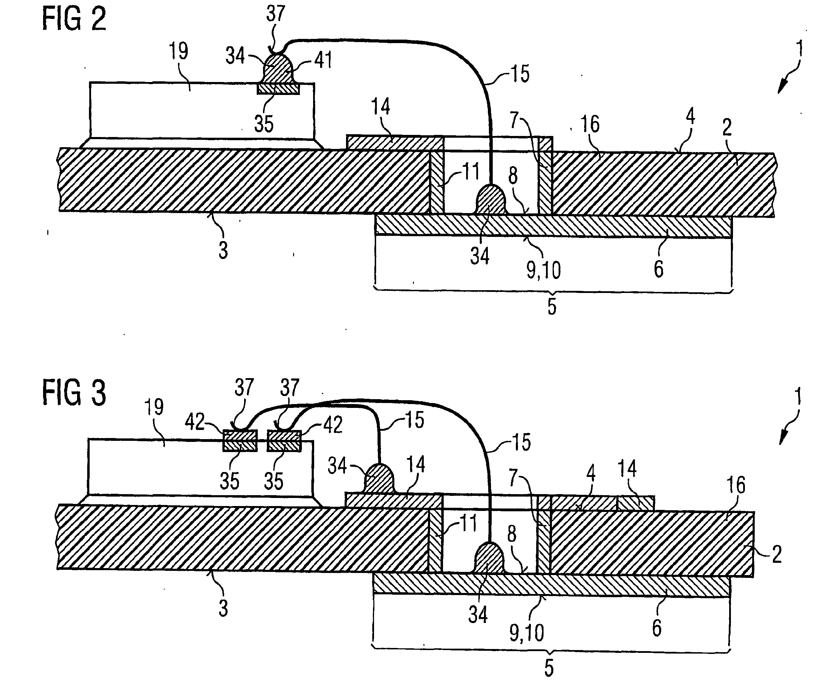

Figur 2 zeigt einen schematischen Querschnitt durch einen Schaltungsträger 1 gemäß einer zweiten Ausführungsform der Erfindung. Komponenten mit gleichen Funktionen wie in Figur 1 werden mit gleichen Bezugszeichen gekennzeichnet und nicht extra erörtert.

In dieser zweiten Ausführungsform der Erfindung wird der Durchkontakt 7 unter dem Anschlusskontakt 6 wie in der Ausführungsfopm nach Figur 1 eingesetzt. Zusätzlich wird durch den Durchkontakt 7 hindurch ein Bonddraht geführt, der mit der Rückseite des Anschlusskontaktes 6 elektrisch verbunden ist. Diese elektrische Verbindung kann durch eine Kompressionstechnik verwirklicht werden, wobei ein Kompressionskopf 34 mit der Rückseite des Anschlusskontaktes 6 verbunden wird. Der Bonddraht wird von der Rückseite des Anschlusskontaktes 6 durch den Durchkontakt 7 hindurch zu einer Kontaktfläche 35 eines Halbleiterchips 19 geführt. Auf einem vorbereiteten Kompressionskopf 41 auf dem Halbleiterchip 19 kann ein Bondbogen 37 aus dem Bonddraht 15 gebildet werden. Für das Bonden kann die Kontaktfläche mit einer bondbaren Metall-Legierung 42 veredelt sein.

Neben der Bondverbindung 15 verfügt der Durchkontakt über eine elektrische Verbindung zu Leiterbahnen 14, die auf der Substratfläche 4 angeordnet sind, welche der Substratfläche 3, auf welcher der Anschlusskontakt 6 angeordnet ist, gegenüber liegt. Die zweite Ausführungsform der Erfindung eröffnet somit dem Verdrahtungsfachmann neue Möglichkeiten, vielseitig die Rückseite der Anschlusskontakte 6 zur Verdrahtung auf einem Schaltungsträger 1 zu nützen.

Figur 3 zeigt einen schematischen Querschnitt durch einen Schaltungsträger 1 gemäß einer dritten Ausführungsform der Erfindung. Komponenten mit gleichen Funktionen wie in den vorhergehenden Figuren werden mit gleichen Bezugszeichen gekennzeichnet und nicht extra erörtert.

Der Unterschied zwischen dieser dritten Ausführungsform der Erfindung und den vorhergehenden beiden Ausführungsformen der Erfindung liegt darin, dass eine dreifache Nutzung der Fläche und des Volumens unterhalb eines Anschlusskontaktes 6 realisiert wird. Darüber hinaus ist ein weiterer Unterschied, dass zur Durchführung von Bonddrahtverbindungen der Bonddraht auf den Kontaktflächen 35 des Halbleiterchips 19 durch einen Kontaktbogen 37 und nicht durch einen Thermokompressionskopf 35 wie ihn Figur 2 zeigt realisiert wird. Die Unterseite oder Rückseite des Anschlusskontaktes 6 wird im Bereich des Durchkontaktes 7 gleich dreifach genutzt. Einerseits durch eine Bondverbindung 15 zu einer Kontaktfläche 35 eines Halbleiterchips 19, zum weiteren durch die metallische Wandung 11 des-Durchkontaktes 7, die eine elektrische Verbindung zwischen der Rückseite 8 des Anschlusskontaktes 6 und Leiterbahnen 14 auf dem Substrat herstellt, und schließlich durch eine an die Wandung 11 des Durchkontaktes herangeführte Leitung 14, die wiederum ihrerseits mit einer Bondverbindung 15 mit den Kontaktflächen 35 des Halbleiterchips verbunden ist.

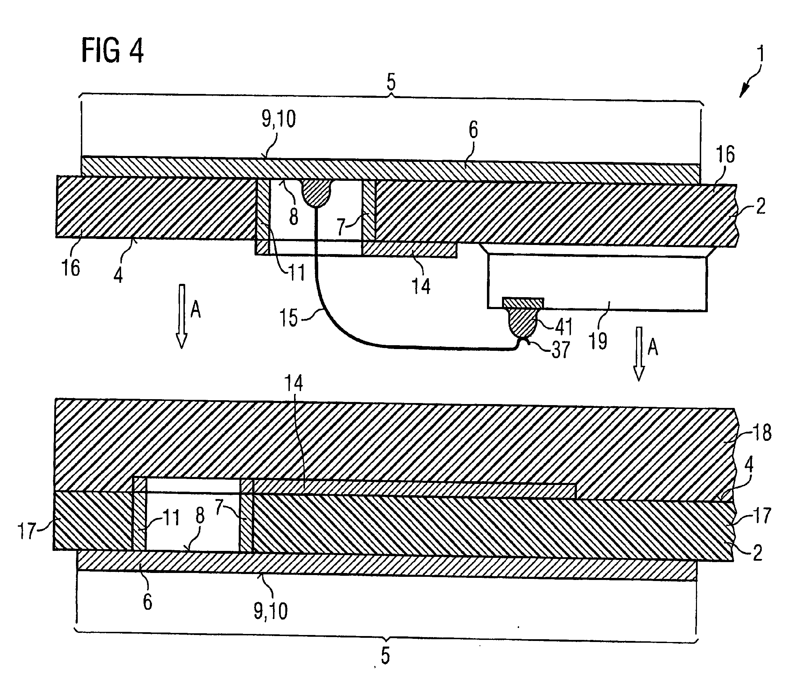

Figur 4 zeigt einen schematischen Querschnitt durch einen Schaltungsträger 1 gemäß einer vierten Ausführungsform der Erfindung aus zwei Komponenten vor einem Zusammenbau desselben. Komponenten mit gleichen Funktionen wie in den vorhergehenden Figuren werden mit gleichen Bezugszeichen gekennzeichnet und nicht extra erörtert.

In dieser Ausführungsform der Erfindung entspricht die erste und obere Komponente des Schaltungsträgers 1 der aus Figur 2 bekannten zweiten Ausführungsform der Erfindung. Die zweite in Figur 4 unter der ersten dargestellten Komponente weist eine Leiterplatte auf, die einen Anschlusskontakt 6 trägt, der über einen Durchkontakt 7 mit einer Leiterbahn 14 auf einem Substrat 2 verbunden ist. Die Leiterbahn 14 und der Durchkontakt 7 sind von einer Kunststoffmasse 18 bedeckt, die aufgeheizt und erschmolzen werden kann. Im schmelzflüssigen Zustand der Kunststoffmasse 18 auf der zweiten Komponente wird die erste Komponente, die der Figur 2 entspricht, mit ihrem Halbleiterchip 19 und dem Bonddraht 15 in Pfeilrichtung A auf die erschmolzene Kunststoffmasse 18 abgesenkt, so dass der Halbleiterchip 19 mit der Bondverbindung 15 von der Kunststoffmasse 18 eingebettet wird.

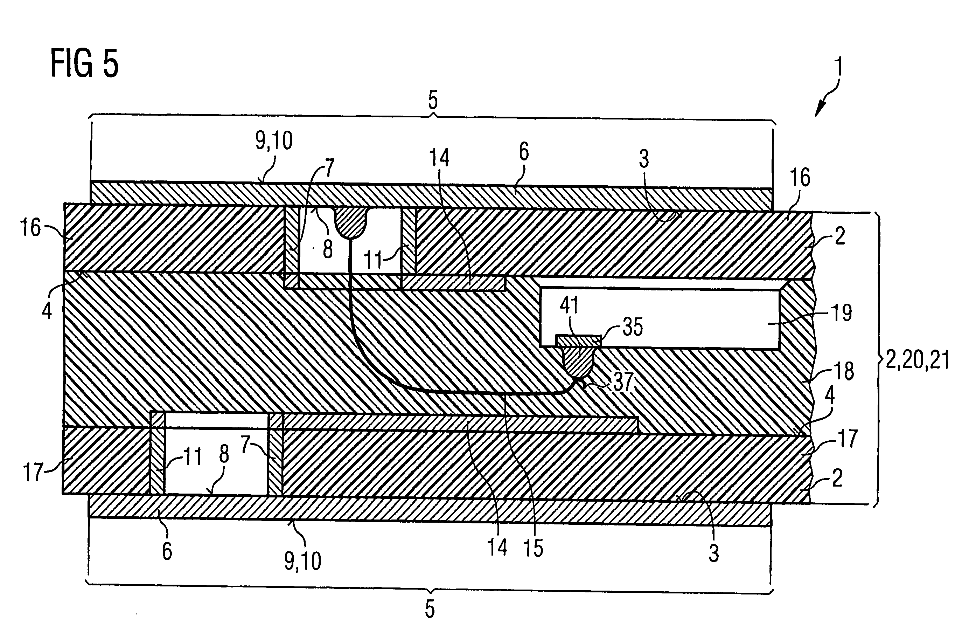

Figur 5 zeigt einen schematischen Querschnitt durch einen Schaltungsträger 1 gemäß der vierten Ausführungsform der Erfindung nach einem Zusammenbau der zwei Komponenten der Figur 4. Komponenten mit gleichen Funktionen wie in den vorhergehenden Figuren werden mit gleichen Bezugszeichen gekennzeichnet und nicht extra erörtert.

Die Kunststoffmasse 18 ist in dieser Darstellung bereits erkaltet und bildet eine isolierende Zwischenschicht zwischen der Leiterbahn 14 der unteren Schaltungsplatte 17 und der Bondverbindung 15, die auf der Schaltungsplatte 16 angeordnet ist und den Halbleiterchip 19 mit der Rückseite 8 des Anschlusskontaktes 6 verbindet. Die Figur 5 zeigt, dass nicht nur Leiterbahnen, Bonddrähte und Durchkontakte unter den Anschlusskontakten 6 angeordnet und untergebracht werden können, sondern auch Halbleiterchips 19 durchaus zwischen den Anschlusskontakten 6 angeordnet werden können. Dadurch wird die Schaltungsdichte des Schaltungsträgers weiter verbessert und gleichzeitig die Miniaturisierung der Schaltungsträger 1 vorangetrieben. Die Schaltungsplatten 16, 17 können auch in Folienform ausgeführt sein und der Schaltungsträger 1 gemäß der vierten Ausführungsform der Erfindung kann eine Chipkarte sein, bei der zwischen zwei Folien Halbleiterchips 19 in einer Kunststoffmasse angeordnet sind und ihre Kontaktflächen 35 elektrisch mit den Anschlusskontakten auf der Oberseite der Durchkontakte und/ oder Bonddrähte verbunden sind.

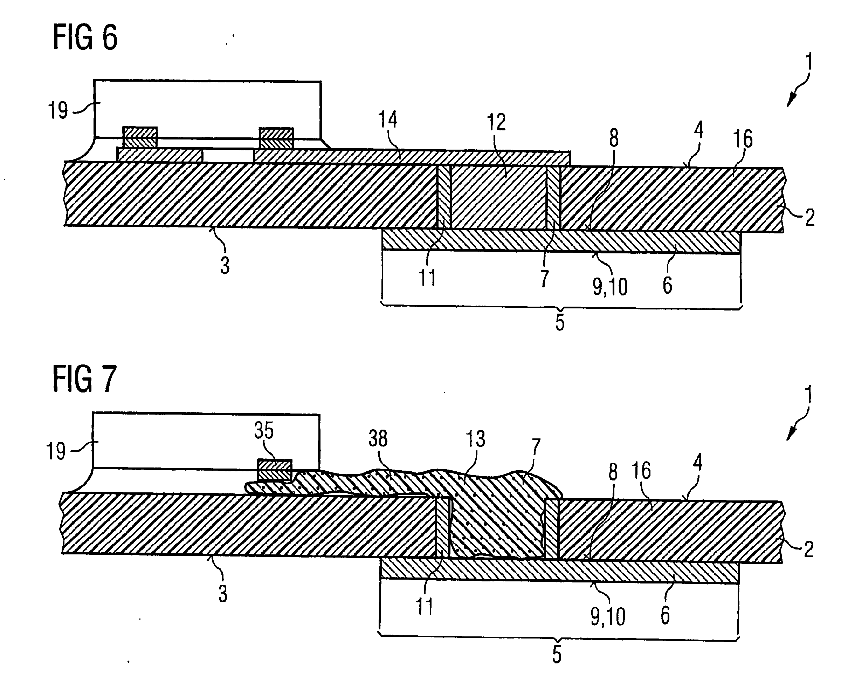

Figur 6 zeigt einen schematischen Querschnitt durch einen Schaltungsträger 1 gemäß einer fünften Ausführungsform der Erfindung. Komponenten mit gleichen Funktionen wie in den vorhergehenden Figuren werden mit gleichen Bezugszeichen gekennzeichnet und nicht extra erörtert.

Ein Unterschied der fünften Ausführungsform gegenüber den vorherigen Ausführungsformen 1 bis 4 liegt darin, dass ein Chip 19 in Flip-Chip-Technik auf den Leiterbahnen 14 angeordnet ist und über einen gefüllten Durchkontakt 7 mit der Rückseite 8 der Anschlusskontakte 6 verbunden ist. Der gefüllte Durchkontakt 7 weist eine galvanisch abgeschiedene, metallische Füllung 12 auf, die jedoch auch durch ein Sinterverfahren mit Hilfe einer Metallpaste eingebracht sein kann. Mit Hilfe der metallischen Füllung 12 wird der Kontaktwiderstand des Durchkontaktes 7 wesentlich vermindert und gleichzeitig wird bei dieser Ausführungsform der Erfindung mit einem Halbleiterchip in Flip-Chip-Technik die Bauteilhöhe wesentlich erniedrigt. Wird beispielsweise mit der fünften Ausführungsform der Erfindung eine Einbettung des Halbleiterchips 19 in eine Kunststoffmasse verwirklicht, wie es in dem Ausführungsbeispiel 4 gezeigt wird, dann kann die Dicke der Kunststoffmasse wesentlich reduziert werden, im Prinzip auf die Dicke des Halbleiterchips 19, da keine Bonddrahtverbindungen vorzusehen sind.

Figur 7 zeigt einen schematischen Querschnitt durch einen Schaltungsträger 1 gemäß einer sechsten Ausführungsform der Erfindung. Komponenten mit gleichen Funktionen wie in den vorhergehenden Figuren werden mit gleichen Bezugszeichen gekennzeichnet und nicht extra erörtert.

Der Unterschied zu den vorhergehenden Ausführungsformen liegt darin, dass der Durchkontakt 7 mit einer leitenden Kunststoffmasse aufgefüllt ist. Diese elektrisch leitende Kunststoffmasse 13 kann auch nachträglich, das heißt nach Aufsetzen und Bestücken des Halbleiterchips 19 auf der Substratfläche 4 bereitgestellt werden. Mit derartigen leitenden Kunststoffmassen wird die Flexibilität der Konstruktion erhöht, da diese metallisch leitenden Kunststoffe auch noch nach Bestükkung des Substrats 2 mit entsprechenden Halbleiterchips 19 erfolgen kann. Das grundlegende Prinzip der vorliegenden Erfindung wird auch bei dieser Ausführungsform der Erfindung verwirklicht, indem der Durchkontakt 7 mit seiner elektrisch leitenden Kunststofffüllung 13 auf der Rückseite 8 des Anschlusskontaktes 6 angeordnet ist und damit die Rückseite 8 des Anschlusskontaktes 6 für eine Verdrahtung genutzt wird.

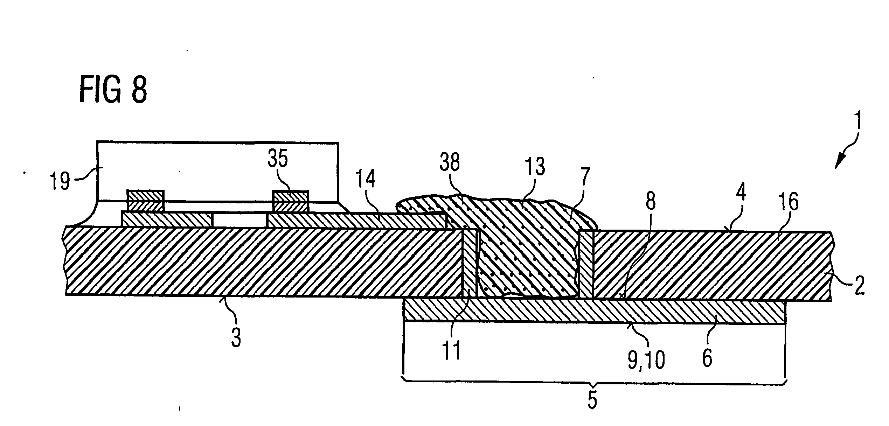

Figur 8 zeigt einen schematischen Querschnitt durch einen Schaltungsträger 1 gemäß einer siebten Ausführungsform der Erfindung. Komponenten mit gleichen Funktionen wie in den vorhergehenden Figuren werden mit gleichen Bezugszeichen gekennzeichnet und nicht extra erörtert.

Die siebte Ausführungsform der Erfindung stellt eine Kombination von vorbereiteten elektrischen Leiterbahnen auf dem Substrat 2 und nachträglich eingebrachten Kunststoffleiterbahnen 14 dar. Dazu ist auf dem Substrat 2 unter dem Anschlusskontakt 6 ein Durchkontakt 7 angeordnet, der über eine nachträglich aufgebrachte Leiterbahn 38 aus elektrisch leitendem Kunststoff mit einer vorher auf dem Substrat angeordneten metallischen Leiterbahn 14 verbunden wird. Diese Ausführungsform der Erfindung vergrößert weiterhin die Variabilität des Entwurfs von Schaltungsträgern 1, da hier noch relativ spät Schaltungsänderungen und Schaltungsanpassungen vorgenommen werden können.

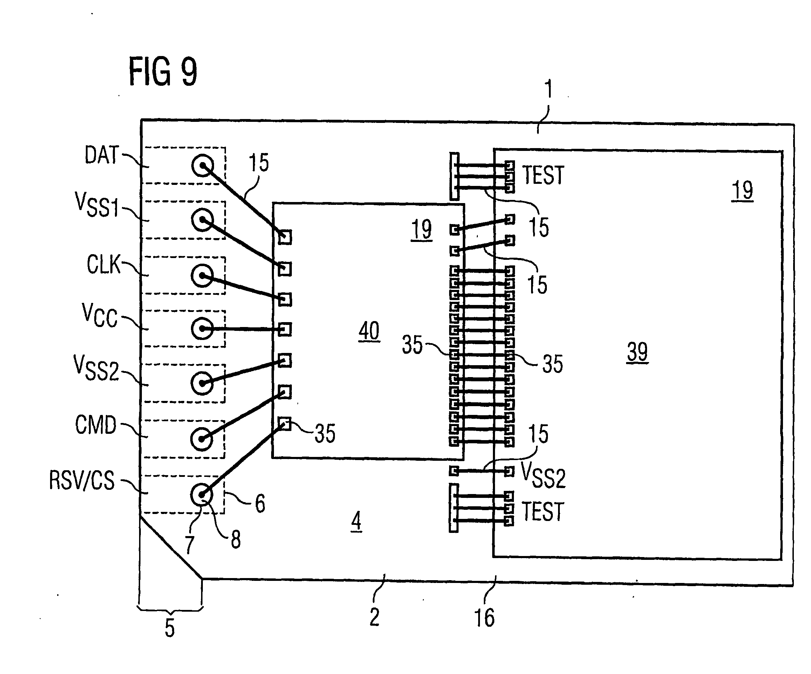

Figur 9 zeigt eine Draufsicht auf eine Bestückungsseite eines Schaltungsträgers 1. Komponenten mit gleichen Funktionen wie in den vorhergehenden Figuren werden mit gleichen Bezugszeichen gekennzeichnet und nicht extra erörtert.

Auf dem Schaltungsträger 1 ist auf der Bestückungsseite ein Speicherchip 39 und ein Logikchip 40 angeordnet, die über Bonddrähte 15 von Chip zu Chip verbunden sind, wobei jeweils eine Kontaktfläche 35 des einen Halbleiterchips mit einer entsprechenden Kontaktfläche 35 des anderen Halbleiterchips verbunden sind. Die Logikschaltung 40 ist wiederum mit einer Reihe von durch gestrichelte Linien gekennzeichnete Anschlusskontakten auf der Rückseite des Speichermoduls verbunden. Dazu sind entsprechende Kontaktflächen 35 des Logikchips 40 über Bonddrähte 15 mit Durchkontakten 7 der Anschlusskontakten 6 elektrisch verbunden. Die Anschlusskontakte 6 werden mit Datensignalen, DAT, mit unterschiedlichen Massepotentialen Vₛₛ₁ und Vₛₛ₂ sowie einer Versorgungsspannung V_{cc} und mit Taktsignalen CLK versorgt. Über einen weiteren Anschlusskontakt 6 werden Befehlssignale CMD an den Logikchip 40 über einen Durchkontakt 7 und einen Bonddraht 15 gelegt. Ein siebter Anschlusskontakt ist für Reserveanschlüsse RSV vorgesehen, wie beispielsweise einen Chip-select-Anschluss CS. Neben den Bondverbindungen 15 von Halbleiterchip zu Halbleiterchip und den Bondverbindungen 15 zwischen Halbleiterchip und Durchkontakten und damit zwischen Halbleiterchip und Anschlusskontakten 6 sind auf dem Schaltungsträger noch Bondverbindungen 15 angeordnet, die beispielsweise für Testzwecke von dem Speicherchip 39 zur Oberfläche 4 des Substrats 2 geführt werden.

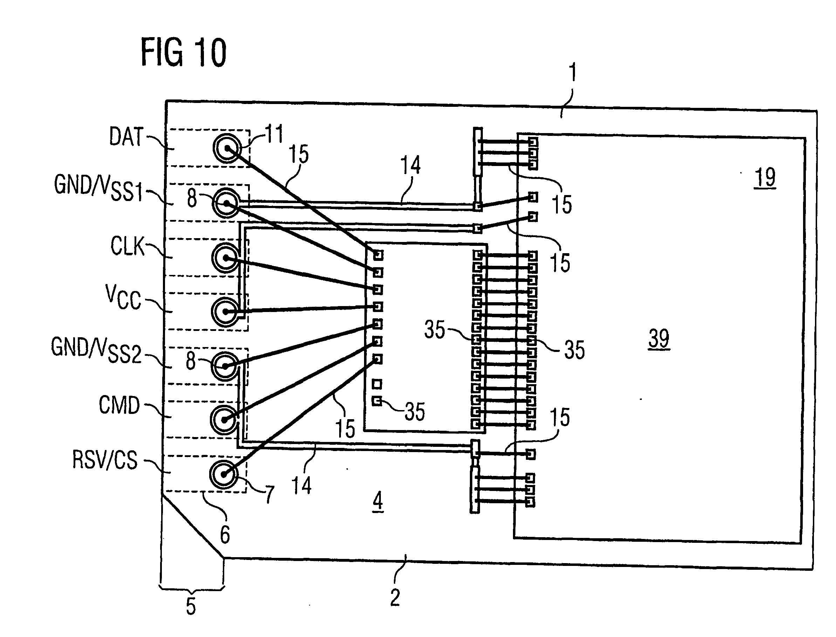

Figur 10 zeigt eine Draufsicht auf eine Bestückungsseite eines Schaltungsträgers 1 einer weiteren Ausführungsform der Erfindung. Komponenten mit gleichen Funktionen wie in den vorhergehenden Figuren werden mit gleichen Bezugszeichen gekennzeichnet und nicht extra erörtert.

Die Ausführungsform der Erfindung gemäß Figur 10 zeigt außer Bonddrähten als Verbindungshilfen auch Leiterbahnen, die unmittelbar auf dem Substrat 2 angeordnet sind. Diese Leiterbahnen 14 verbinden beispielsweise die unterschiedlichen Massepotentiale Vₛₛ₁ und Vₛₛ₂ mit dem Speicherchip 39. Die Figur 10 zeigt somit die hohe Flexibilität, die durch Einsatz von Durchkontakten im Bereich der Anschlusskontakte 6 erreicht werden kann. Die Anschlusskontakte 6 sind auf der der Bestükkungsseite gegenüberliegenden Fläche des Substrats 2 angeordnet und deshalb mit gestrichelten Linien gekennzeichnet. Im Bereich der Anschlusskontakte 6 sind die Durchkontakte 7 einerseits mit Leiterbahnen 14 auf dem Substrat 2 und andererseits mit Bonddrähten 15 verbunden, so dass die erfindungsgemäßen Durchkontakte 7 zu den Anschlusskontakten 6 einer Schaltungsträgerplatte 1 die Möglichkeiten des Schaltungs-Layouters wesentlich verbessern.

## Patentansprüche

1. Schaltungsträger, der ein Substrat (2) mit zwei gegenüberliegend angeordneten Flächen (3, 4) aufweist, wobei ein Randbereich (5) mindestens einer der Flächen (3, 4) Anschlusskontakte (6) einer Flachsteckerleiste in einem vorgegebenen Rastermaß aufweist, und wobei mindestens ein Durchkontakt (7) unter einem der Anschlusskontakte (6) mit verdeckter elektrischer Verbindung zu der Rückseite (8) des Anschlusskontaktes (6) angeordnet ist und die Oberseite (9) des Anschlusskontaktes (6) eine ungestörte Morphologie und ebene Oberfläche (10) aufweist.

2. Schaltungsträger nach Anspruch 1,
**dadurch gekennzeichnet, dass**
der Durchkontakt (7) eine metallische Wandbeschichtung (11) aufweist, welche die Rückseite des Anschlusskontaktes (6) berührt.

3. Schaltungsträger nach Anspruch 1 oder Anspruch 2,
**dadurch gekennzeichnet, dass**
der Durchkontakt (7) eine metallische Füllung (12) aufweist, welche die Rückseite (8) des Anschlusskontaktes (6) berührt.

4. Schaltungsträger nach einem der vorhergehenden Ansprüche,
**dadurch gekennzeichnet, dass**
der Durchkontakt (7) eine Füllung aus elektrisch leitendem Kunststoff (13) aufweist, welcher die Rückseite (8) des Anschlusskontaktes (6) berührt.

5. Schaltungsträger nach einem der vorhergehenden Ansprüche,
**dadurch gekennzeichnet, dass**
die von den Anschlusskontakten (6) abgewandte Fläche (4) des Substrats (2) mindestens eine Leiterbahn (14) aufweist, die mit dem Durchkontakt (7) verbunden ist.

6. Schaltungsträger nach Anspruch 5,
**dadurch gekennzeichnet, dass**
die Leiterbahn (14) einen elektrisch leitenden Kunststoff (13) aufweist.

7. Schaltungsträger nach einem der vorhergehenden Ansprüche,
**dadurch gekennzeichnet, dass**
ein Bonddraht (15) in dem Durchkontakt (7) angeordnet ist, der unmittelbar auf die Rückseite (8) des Anschlusskontaktes (6) gebondet ist.

8. Schaltungsträger nach einem der vorhergehenden Ansprüche,
**dadurch gekennzeichnet, dass**
der elektrisch leitende Kunststoff (13) elektrisch leitende Mikro- oder Nanopartikel aufweist.

9. Schaltungsträger nach einem der vorhergehenden Ansprüche,
**dadurch gekennzeichnet, dass**
der elektrisch leitende Kunststoff (13) als Ausgangsstoff einen mit Nanopartikeln angereicherten in N-methyl-Pyrrolidin gelösten Polyamidessigsäureester aufweist.

10. Schaltungsträger nach einem der vorhergehenden Ansprüche,
**dadurch gekennzeichnet, dass**
der elektrisch leitende Kunststoff (13) Katalysatormaterialien und Haftvermittler in einer Kunststoffgrundmasse aus Polyamid zusätzlich zu den Nanopartikeln aufweist.

11. Schaltungsträger nach einem der vorhergehenden Ansprüche,
**dadurch gekennzeichnet, dass**
der Schaltungsträger (1) als Substrat (2) zwei Schaltungsplatten (16, 17) mit dazwischen in Kunststoffmasse (18) eingebetteten Halbleiterchips (19) aufweist.

12. Schaltungsträger nach einem der vorhergehenden Ansprüche,
**dadurch gekennzeichnet, dass**
das Substrat eine mehrlagige Leiterplatte (20) aufweist.

13. Schaltungsträger nach einem der vorhergehenden Ansprüche,
**dadurch gekennzeichnet, dass**
das Substrat eine mehrlagige Keramikplatte (21) aufweist.

14. Schaltungsträger nach einem der vorhergehenden Ansprüche,
**dadurch gekennzeichnet, dass**
das der Durchkontakt (7) eine Mehrfachverbindung aus elektrisch leitenden Übergängen zu einem Anschlusskontakt (6), zu Leiterbahnen (14) auf der dem Anschlusskontakt (6) gegenüberliegenden Fläche (4) des Substrats (2) und/oder zu Bonddrahtanschlüssen (15) aufweist.

15. Verfahren zur Herstellung eines Schaltungsträgers (1), der ein Substrat (2) mit Anschlusskontakten (6) in einem vorgegebenen Rastermaß aufweist, und wobei mindestens ein Durchkontakt (7) unter einem der Anschlusskontakte (6) mit verdeckter elektrischer Verbindung zu der Rückseite (8) des Anschlusskontaktes (6) angeordnet ist, wobei das Verfahren folgende Verfahrensschritte aufweist:
- Bereitstellen eines isolierenden Substrats (2),
- Einbringen von Durchgangslöchern in das Substrat (2) in Bereichen, die für Anschlusskontakte (6) vorgesehen sind,
- Beschichten der Wandungen der Durchgangslöcher (7),
- Aufbringen von Anschlusskontakten (6) auf das Substrat (2) unter Abdecken der metallisierten Durchgangslöcher (7) mit einer im Bereich der Durchkontakte (7) selbsttragenden und formstabilen Metallfolie und
- Strukturieren der Metallfolie unter Herstellen einer elektrischen Verbindung zwischen Rückseite (8) der Anschlusskontakte (6) und der Metallisierung der Durchgangslöcher.

16. Verfahren zur Herstellung eines Schaltungsträgers (1), der ein Substrat (2) mit Anschlusskontakten (6) in einem vorgegebenen Rastermaß aufweist, und wobei mindestens ein Durchkontakt (7) unter einem der Anschlusskontakte (6) mit verdeckter elektrischer Verbindung zu der Rückseite (8) des Anschlusskontaktes (6) angeordnet ist, wobei das Verfahren folgende Verfahrensschritte aufweist:
- Bereitstellen eines isolierenden Substrats (2) mit beidseitig aufgebrachter Metallfolie,
- Strukturieren der Metallfolie mit Anschlußkontakten (8),
- Einbringen von Durchgangslöchern in das Substrat (2) in Bereichen der Anschlusskontakte (6) mittels Laserabtragen des isolierenden Substratmaterials,
- Beschichten der Wandungen der Durchgangslöcher (7), unter Herstellen einer elektrischen Verbindung zwischen Rückseite (8) der Anschlusskontakte (6) und der Metallisierung der Durchgangslöcher.

17. Verfahren zur Herstellung eines Schaltungsträgers (1), der ein Substrat (2) mit Anschlusskontakten (6) in einem vorgegebenen Rastermaß aufweist, und wobei mindestens ein Durchkontakt (7) unter einem der Anschlusskontakte (6) mit verdeckter elektrischer Verbindung zu der Rückseite (8) des Anschlusskontaktes (6) angeordnet ist, wobei das Verfahren folgende Verfahrensschritte aufweist:
- Bereitstellen eines isolierenden Substrats (2),
- Einbringen von Durchgangslöchern in das Substrat (2) in Bereichen, die für Anschlusskontakte (6) vorgesehen sind,
- beidseitiges Aufbringen von nicht selbsttragenden Metallfolien auf das Substrat,
- Strukturieren der Metallfolien derart, daß die Durchgangslöcher (7) einseitig von der nicht selbsttragenden Metallfolie bedeckt bleiben,
- galvanisches Verdicken der strukturierten Metallfolien bei gleichzeitigem Beschichten der Wandungen der Durchgangslöcher (7).

18. verfahren nach einem der Ansprüche 15 - 17,
**dadurch gekennzeichnet, dass**
auf die den Anschlusskontakten (6) gegenüberliegende Fläche (4) Leiterbahnen (14) aufgebracht werden.

19. Verfahren nach einem der Ansprüche 15 - 18,
**dadurch gekennzeichnet, dass**
ein oder mehrere Halbleiterchips (19) in Flip-Chip Technik mit den Leiterbahnen (14) verbunden werden.

20. Verfahren nach einem der Ansprüche 15 bis 18,
**dadurch gekennzeichnet, dass**
ein oder mehrere Halbleiterchips (19) in Bond-Technik mit den Leiterbahnen (14) verbunden werden.

21. Verfahren nach einem der Ansprüche 15 bis 20,
**dadurch gekennzeichnet, dass**
Leiterbahnen (14) aus elektrisch leitendem Kunststoff (13) auf die den Anschlusskontakten (6) gegenüberliegende Fläche (4) des Substrats (2) aufgebracht werden.

## Claims

1. Circuit carrier having a substrate (2) with two oppositely arranged areas (3, 4), an edge region (5) of at least one of the areas (3, 4) having terminal contacts (6) of a flat connector strip in a predetermined grid dimension, and at least one through contact (7) being arranged under one of the terminal contacts (6) with concealed electrical connection to the rear side (8) of the terminal contact (6), and the top side (9) of the terminal contact (6) having an undisturbed morphology and planar surface (10).

2. Circuit carrier according to Claim 1,
**characterized in that**
the through contact (7) has a metallic wall coating (11) that touches the rear side of the terminal contact (6).

3. Circuit carrier according to Claim 1 or Claim 2,
**characterized in that**
the through contact (7) has a metallic filling (12) that touches the rear side (8) of the terminal contact (6).

4. Circuit carrier according to one of the preceding claims,
**characterized in that**
the through contact (7) has a filling made of electrically conductive plastic (13) that touches the rear side (8) of the terminal contact (6).

5. Circuit carrier according to one of the preceding claims,
**characterized in that**
the area (4) of the substrate (2) that is remote from the terminal contacts (6) has at least one conductor track (14) connected to the through contact (7).

6. Circuit carrier according to Claim 5,
**characterized in that**
the conductor track (14) has an electrically conductive plastic (13).

7. Circuit carrier according to one of the preceding claims,
**characterized in that**
a bonding wire (15) is arranged in the through contact (7), which is bonded directly onto the rear side (8) of the terminal contact (6).

8. Circuit carrier according to one of the preceding claims,
**characterized in that**
the electrically conductive plastic (13) has electrically conductive micro- or nanoparticles.

9. Circuit carrier according to one of the preceding claims,
**characterized in that**
the electrically conductive plastic (13) has as starting material, a polyamide acetic acid ester that is enriched with nanoparticles and dissolved in N-methyl-pyrrolidine.

10. Circuit carrier according to one of the preceding claims,
**characterized in that**
the electrically conductive plastic (13) has catalyst materials and adhesion promoters in a basic plastics composition made of polyamide in addition to the nanoparticles.

11. Circuit carrier according to one of the preceding claims,
**characterized in that**
the circuit carrier (1) has, as the substrate (2), two circuit boards (16, 17) with semiconductor chips (19) embedded in plastics composition (18) in between.

12. Circuit carrier according to one of the preceding claims,
**characterized in that**
the substrate has a multilayer printed circuit board (20).

13. Circuit carrier according to one of the preceding claims,
**characterized in that**
the substrate has a multilayer ceramic board (21).

14. Circuit carrier according to one of the preceding claims,
**characterized in that**
the through contact (7) has a multiple connection made of electrically conductive transitions to a terminal contact (6), to conductor tracks (14) on the area (4) of the substrate (2) that is opposite to the terminal contact (6), and/or to bonding wire terminals (15).

15. Method for producing a circuit carrier (1) having a substrate (2) with terminal contacts (6) in a predetermined grid dimension, and at least one through contact (7) being arranged under one of the terminal contacts (6) with concealed electrical connection to the rear side (8) of the terminal contact (6), the method having the following method steps:
- provision of an insulating substrate (2),
- introduction of passage holes into the substrate (2) in regions provided for terminal contacts (6),
- coating of the walls of the passage holes (7),
- application of terminal contacts (6) to the substrate (2) with the metallized passage holes (7) being covered with a metal foil that is dimensionally stable and self-supporting in the region of the through contacts (7),
- patterning of the metal foil to produce an electrical connection between the rear side (8) of the terminal contacts (6) and the metallization of the passage holes.

16. Method for producing a circuit carrier (1) having a substrate (2) with terminal contacts (6) in a predetermined grid dimension, and at least one through contact (7) being arranged under one of the terminal contacts (6) with concealed electrical connection to the rear side (8) of the terminal contact (6), the method having the following method steps:
- provision of an insulating substrate (2) with metal foil applied on both sides,
- patterning of the metal foil with terminal contacts (8),
- introduction of passage holes into the substrate (2) in regions of the terminal contacts (6) by means of laser removal of the insulating substrate material,
- coating of the walls of the passage holes (7), to produce an electrical connection between the rear side (8) of the terminal contacts (6) and the metallization of the passage holes.

17. Method for producing a circuit carrier (1) having a substrate (2) with terminal contacts (6) in a predetermined grid dimension, and at least one through contact (7) being arranged under one of the terminal contacts (6) with concealed electrical connection to the rear side (8) of the terminal contact (6), the method having the following method steps:
- provision of an insulating substrate (2),
- introduction of passage holes into the substrate (2) in regions provided for terminal contacts (6),
- application of non-self-supporting metal foils to the substrate on both sides,
- patterning of the metal foils in such a way that the passage holes (7) remain covered by the non-self-supporting metal foil on one side,
- galvanic thickening of the patterned metal foils with simultaneous coating of the walls of the passage holes (7).

18. Method according to one of Claims 15-17,
**characterized in that**
conductor tracks (14) are applied to the area (4) opposite to the terminal contacts (6).

19. Method according to one of Claims 15-18,
**characterized in that**
one or a plurality of semiconductor chips (19) are connected to the conductor tracks (14) using flip-chip technology.

20. Method according to one of Claims 15 to 18,
**characterized in that**
one or a plurality of semiconductor chips (19) are connected to the conductor tracks (14) using bonding technology.

21. Method according to one of Claims 15 to 20,
**characterized in that**
conductor tracks (14) made of electrically conductive plastic (13) are applied to the area (4) of the substrate (2) that is opposite to the terminal contacts (6) .

## Revendications

1. Support de circuit qui présente un substrat (2) avec deux surfaces (3, 4) opposées, une zone de bordure (5) d'au moins l'une des surfaces (3, 4) présentant des contacts de raccordement (6) d'une barrette enfichable plate dans une cote modulaire donnée et au moins un contact traversant (7) étant disposé sous l'un des contacts de raccordement (6) avec une liaison électrique couverte vers le côté arrière (8) du contact de raccordement (6) et le côté supérieur (9) du contact de raccordement (6) présentant une morphologie non perturbée et une surface (10) plane.

2. Support de circuit selon la revendication 1, **caractérisé en ce que** le contact traversant (7) présente un revêtement métallique de la paroi (11) qui touche le côté arrière du contact de raccordement (6).

3. Support de circuit selon la revendication 1 ou la revendication 2, **caractérisé en ce que** le contact traversant (7) présente un remplissage métallique (12) qui touche le côté arrière (8) du contact de raccordement (6).

4. Support de circuit selon l'une des revendications précédentes, **caractérisé en ce que** le contact traversant (7) présente un remplissage en matière plastique conductrice d'électricité (13) qui touche le côté arrière (8) du contact de raccordement (6).

5. Support de circuit selon l'une des revendications précédentes, **caractérisé en ce que** la surface (4) du substrat (2) à l'opposé des contacts de raccordement (6) présente au moins une piste conductrice (14) qui est reliée au contact traversant (7).

6. Support de circuit selon la revendication 5, **caractérisé en ce que** la piste conductrice (14) présente une matière plastique conductrice d'électricité (13).

7. Support de circuit selon l'une des revendications précédentes, **caractérisé en ce qu'**un fil de liaison (15) est disposé dans le contact traversant (7), lequel est relié directement sur le côté arrière (8) du contact de raccordement (6).

8. Support de circuit selon l'une des revendications précédentes, **caractérisé en ce que** la matière plastique conductrice d'électricité (13) présente des microparticules ou des nanoparticules conductrices d'électricité.

9. Support de circuit selon l'une des revendications précédentes, **caractérisé en ce que** la matière plastique conductrice d'électricité (13) présente comme matière première un acétate de polyamide dissout dans du N-méthyle-pyrrolidine enrichie de nanoparticules.

10. Support de circuit selon l'une des revendications précédentes, **caractérisé en ce que** la matière plastique conductrice d'électricité (13) présente en plus des nanoparticules des matériaux catalytiques et des agents adhésifs dans une masse de base en matière plastique polyamide.

11. Support de circuit selon l'une des revendications précédentes, **caractérisé en ce que** le support de circuit (1) présente comme substrat (2) deux plaques de circuit (16, 17) entre lesquelles des puces en semiconducteur (19) sont scellées dans une masse de matière plastique (18).

12. Support de circuit selon l'une des revendications précédentes, **caractérisé en ce que** le substrat présente un circuit imprimé multicouche (20).

13. Support de circuit selon l'une des revendications précédentes, **caractérisé en ce que** le substrat présente une plaque en céramique multicouche (21).

14. Support de circuit selon l'une des revendications précédentes, **caractérisé en ce que** le contact traversant (7) présente une liaison multiple en transitions conductrices d'électricité vers un contact de raccordement (6), vers les pistes conductrices (14) sur 1a surface (4) du substrat (2) à l'opposé du contact de raccordement (6) et/ou vers les bornes de fil de liaison (15).

15. Procédé de fabrication d'un support de circuit (1) qui présente un substrat (2) avec des contacts de raccordement (6) dans une cote modulaire donnée et au moins un contact traversant (7) étant disposé sous l'un des contacts de raccordement (6) avec une liaison électrique couverte vers le côté arrière (8) du contact de raccordement (6), le procédé présentant les étapes suivantes ;
- Mise à disposition d'un substrat (2) isolé,
- Aménagement de trous traversants dans le substrat (2) dans les zones qui sont prévues pour les contacts de raccordement (6),
- Application d'un revêtement sur les parois des trous traversants (7),
- Application de contacts de raccordement (6) sur le substrat (2) en recouvrant les trous traversants (7) métallique d'un film de métal autoporteur et indéformable dans la zone des contacts traversants (7) et
- Structuration du film métallique en établissant une liaison électrique entre le côté arrière (8) des contacts de raccordement (6) et la métallisation des trous traversants.

16. Procédé de fabrication d'un support de circuit (1) qui présente un substrat (2) avec des contacts de raccordement (6) dans une cote modulaire donnée et au moins un contact traversant (7) étant disposé sous l'un des contacts de raccordement (6) avec une liaison électrique couverte vers le côté arrière (8) du contact de raccordement (6), le procédé présentant les étapes suivantes :
- Mise à disposition d'un substrat (2) isolé des deux côtés duquel est appliqué un film métallique,
- Structuration du film métallique avec des contacts de raccordement (8),
- Aménagement de trous traversants dans le substrat (2) dans les zones des contacts de raccordement (6) par enlèvement au laser du matériau isolant du substrat,
- Application d'un revêtement sur les parois des trous traversants (7) en réalisant une liaison électrique entre le côté arrière (8) des contacts de raccordement (6) et la métallisation des trous traversants.

17. Procédé de fabrication d'un support de circuit (1) qui présente un substrat (2) avec des contacts de raccordement (6) dans une cote modulaire donnée et au moins un contact traversant (7) étant disposé sous l'un des contacts de raccordement (6) avec une liaison électrique couverte vers le côté arrière (8) du contact de raccordement (6), le procédé présentant les étapes suivantes :
- Mise à disposition d'un substrat (2) isolé,
- Aménagement de trous traversants dans le substrat (2) dans les zones qui sont prévues pour les contacts de raccordement (6),
- Application des deux côtés du substrat de films métalliques non autoporteurs,
- Structuration des films métalliques de telle sorte que les trous traversants (7) restent recouverts d'un côté par le film métallique non autoporteur,
- Épaississement galvanique des films métalliques avec application simultanée d'un revêtement sur les parois des trous traversants (7).

18. Procédé selon l'une des revendications 15 à 17, **caractérisé en ce que** des pistes conductrices (14) sont appliquées sur la surface (4) à l'opposé des contacts de raccordement (6).

19. Procédé selon l'une des revendications 15 à 18, **caractérisé en ce que** une ou plusieurs puces en semiconducteur (19) sont reliées avec les pistes conductrices (14) en technique « Flip-Chip ».

20. Procédé selon l'une des revendications 15 à 18, **caractérisé en ce que** une ou plusieurs puces en semiconducteur (19) sont reliées avec les pistes conductrices (14) en technique de bonding.

21. Procédé selon l'une des revendications 15 à 20, **caractérisé en ce que** des pistes conductrices (14) en matière plastique conductrice d'électricité (13) sont appliquées sur la surface (4) du substrat (2) à l'opposé des contacts de raccordement (6).
